# EUROPÄISCHE PATENTSCHRIFT

(11) **EP 4 493 945 B1**
(45) Veröffentlichungstag und Bekanntmachung des Hinweises auf die Patenterteilung: **23.07.2025**
(21) Anmeldenummer: 24707035.2
(22) Anmeldetag: 22.02.2024
(51) Int. Cl.: G01R 31/392

(54) **VERFAHREN ZUR BESTIMMUNG DER ALTERUNG EINER BATTERIEEINZELZELLE SOWIE VERFAHREN ZUR STEUERUNG EINER BATTERIE**
METHOD FOR DETERMINING THE AGEING OF A SINGLE BATTERY CELL AND METHOD FOR CONTROLLING A BATTERY
PROCÉDÉ DE DÉTERMINATION DE VIEILLISSEMENT D'ÉLÉMENT DE BATTERIE INDIVIDUEL ET PROCÉDÉ DE COMMANDE DE BATTERIE

(30) Priorität: 29.03.2023 DE 102023001210
(43) Veröffentlichungstag der Anmeldung: 22.01.2025
(73) Patentinhaber: Mercedes-Benz Group AG, 70372 Stuttgart (DE)
(72) Erfinder: HUST, Friedrich Emanuel, 73734 Esslingen (DE); WITZENHAUSEN, Heiko, 73728 Esslingen (DE)
(74) Vertreter: Novagraaf Group
(86) Internationale Anmeldenummer: PCT/EP2024/054539
(87) Internationale Veröffentlichungsnummer: WO 2024/199836

(56) Entgegenhaltungen:
- US-A1- 2015 377 976
- FRIEDRICH EMANUEL HUST: "Physico-Chemically Motivated Parameterization and Modelling of Real-Time Capable Lithium-Ion Battery Models - a Case Study on the Tesla Model S Battery", AACHENER BEITRÄGE DES ISEA, 1 January 2019 (2019-01-01), pages 1 - 218, XP093161274, Retrieved from the Internet <URL:https://publications.rwth-aachen.de/record/752755/files/752755.pdf> [retrieved on 20240512], DOI: 10.18154/RWTH-2019-00249

## Beschreibung

Die Erfindung betrifft ein Verfahren zur Bestimmung der Alterung einer Batterieeinzelzelle einer Lithium-Ionen-Batterie. Außerdem betrifft die Erfindung ein Verfahren zum Steuern einer Batterie nach der im Oberbegriff von Anspruch 11 näher definierten Art.

Aktuelle Lithium-Ionen-Batterien, wie sie häufig als Hochenergiebatterien für die elektrische Leistungsversorgung von Kraftfahrzeugen eingesetzt werden, basieren häufig auf Nickel-Mangan-Kobalt-Elektroden und Graphitelektroden. Dabei weist insbesondere die Graphitelektrode Alterungseffekte auf, welche die Performance der gesamten Batterie bzw. ihrer Batterieeinzelzellen betreffen. Um diesen Alterungseffekten bereits im Lebenszyklus der Batterie entgegenwirken zu können, um zumindest eine beschleunigte Alterung zu unterbinden, müssen entsprechende Indikatoren für solche Alterungsfaktoren vermessen und korrekt interpretiert werden.

Eine häufig eingesetzte Analysetechnik ist dabei die sogenannte differenzielle Spannungsanalyse (Differential Voltage Analysis; DVA). Mit Hilfe dieser Technik lässt sich die Homogenität der Lithiumverteilung innerhalb der Batterie bestimmen. Die Technik benötigt allerdings eine Vollladung und eine vollständige Entladung mit einem möglichst kleinen und konstanten Strom. Dies ist im realen Einsatz, insbesondere beim Einsatz in einem Kraftfahrzeug, kaum möglich, da hier die Ladung möglichst schnell, also mit hohem Strom, und daher immer am Rande des Stabilitätsfensters, also unmittelbar vor dem Bereich, in dem eine Deckschichtbildung der Anode auftreten würde, durchgeführt wird. In der Entladerichtung liegt ebenfalls eine hohe Dynamik vor, oft unterbrochen von kurzen Ladezyklen, da es häufig beim Beschleunigen zu einem sehr starken Entladen und beim Wiederabbremsen zu einem Rekuperieren, also einem erneuten Laden der Batterie, kommt. Hiermit liegt also einerseits keine konstante Belastung vor und andererseits wechselt die Stromrichtung immer wieder. Diese in der Praxis auftretenden Bedingungen sind also für eine differentielle Spannungsanalyse prinzipiell ungeeignet. Die Erkennung von Alterungsmechanismen im Betrieb wird dadurch erschwert und, wenn diese nicht erkannt werden können, kann ihnen auch nicht effizient entgegengewirkt werden.

US 2015/377976 A1 offenbart adaptives Laden einer Batteriezelle unter Verwendung ihres Gesundheitszustands.

In der Dissertation eines der Erfinder, unter dem Titel "Physico-chemically motivated parameterization and modelling of real-time capable lithium-ion battery models: a case study on the Tesla Model S battery" von Hust, Friedrich Emanuel, RWTH Aachen, dort veröffentlicht 2019 (DOI: 10.18154/RWTH-2019-00249) wird ein physikalisch-chemisch motiviertes impedanzbasiertes und echtzeitfähiges Lithium-Ionen-Modell vorgestellt und auf Basis von Batterieeinzelzellen aus einem Tesla Modell S parametriert. Unter anderem wurde darin das Relaxationsverhalten der Batterieeinzelzellen untersucht, wobei festgestellt wurde, dass dieses im Wesentlichen durch die negative Elektrode, also die Graphitelektrode, hervorgerufen wird. In der Dissertation wird angenommen, dass die Relaxation durch die Umverteilung von Lithium innerhalb der Graphitelektrode verursacht wird. Auf Basis dieser Erkenntnisse konnten nun weitere Untersuchungen anhand des Lithium-Ionen-Batteriemodells mit weiterer Parametrisierung durch weitere reale Zellen erfolgen.

Basierend auf diesen Grunderkenntnissen ist es die Aufgabe der hier vorliegenden Erfindung ein Verfahren zur Bestimmung der Alterung einer Batterieeinzelzelle in einer Lithium-Ionen-Batterie anzugeben, welches für den dynamischen Praxisbetrieb geeignet ist, um so aus dem erkannten Alterungsverhalten in der Lage zu sein, die Betriebsstrategie der Batterie anzupassen.

Erfindungsgemäß wird diese Aufgabe durch ein Verfahren zur Bestimmung der Alterung einer Batterieeinzelzelle einer Lithium-Ionen-Batterie mit den Merkmalen im Anspruch 1 gelöst. Vorteilhafte Ausgestaltungen und Weiterbildungen ergeben sich aus den hiervon abhängigen Unteransprüchen. Außerdem löst ein Verfahren zum Steuern einer Batterie mit wenigstens einer Batterieeinzelzelle, für welche die Alterung bestimmt worden ist, und den Merkmalen im Anspruch 11 die Aufgabe. Auch hier ergeben sich vorteilhafte Ausgestaltungen aus den hiervon abhängigen Unteransprüchen.

Bei dem erfindungsgemäßen Verfahren ist es so, dass die Batterieeinzelzelle mit einem Leistungspuls aktiv be- oder entladen wird, oder ein solcher die Batterieeinzelzelle ladender oder entladender Leistungspuls im Betrieb der Batterie detektiert wird. Das Verfahren lässt sich also einerseits aktiv anstoßen, indem zu einem geeigneten Zeitpunkt, beispielsweise bei einem in einem Fahrzeug verbauten Batterie, wenn diese aktuell nicht benötigt wird, ein entsprechender Leistungspuls zum Laden und/oder Entladen ausgelöst wird. In der Praxis relevanter dürfte jedoch der Fall sein, dass ein solcher Leistungspuls im regulären Betrieb der Batterie auftritt, also dass beispielsweise beschleunigt oder scharf abgebremst wird. Dadurch erfolgt ein Entladen oder ein durch Rekuperation bedingtes Laden der Batterie und damit ihrer Batterieeinzelzellen. Ein solcher Leistungspuls während des regulären dynamischen Betriebs der Batterie also einfach detektiert und für das erfindungsgemäße Verfahren genutzt werden. In einer auf einen solchen Leistungspuls folgenden Leerlaufphase wird dann neben dem zuvor aufgetretenen Strompuls die Spannungsantwort der Batterieeinzelzelle aufgezeichnet. Die Leerlaufphase kann dabei eine Phase mit geringer Leistung oder auch eine Phase ohne Leistung sein, beispielsweise wenn ein Fahrzeug nach dem scharfen Abbremsen an einer roten Ampel steht.

Besonders günstig ist auch eine kontinuierliche Aufzeichnung von Strom und Spannung, in welcher dann, nach einem erkannten Leistungspuls und einer darauf folgenden Leerlaufphase, die Auswertung der aufgezeichneten Daten im nachfolgend beschriebenen Sinn erfolgen kann. Entscheidend ist es hier nun, dass erfindungsgemäß aus dieser Spannungsantwort eine Relaxationszeitkonstante ermittelt und gespeichert wird. Dies ist soweit auch grundlegend aus der eingangs genannten Dissertation zum Stand der Technik bekannt, wird dort jedoch nicht in dem hier beschriebenen Sinne angewandt.

Die ermittelten und gespeicherten Relaxationszeitkonstanten lassen sich dann nutzen, um basierend auf zuletzt gespeicherten Relaxationszeitkonstanten und der aktuell ermittelten Relaxationszeitkonstante entweder beim Laden oder beim Entladen jeweils eine Ladekurve und aus weiteren Daten eine Entladekurve über der Ladung der Batterieeinzelzelle zu bilden. Die Lade- und die Entladekurve bilden dann einen Schnittpunkt aus, welcher es erlaubt, auf eine aktuelle Kapazität der Batterieeinzelzelle, und hier insbesondere der Graphitelektrode, zu schließen. Damit lassen sich erste Grundlagen für die Bestimmung der Alterung der Batterieeinzelzelle schaffen, welche dann ein Betriebsverfahren ermöglichen, welches entsprechend schonend mit den gealterten Batterieeinzelzellen umgeht, um das Fortschreiten ihrer Alterung zu unterbinden oder zumindest zu minimieren.

Vorzugsweise kann dies anhand des durch den Schnittpunkt bestimmten Übergangs von einer Stufe einer Ruhespannungskurve von Lithium gegenüber Graphit über der Kapazität der Batterieeinzelzelle bzw. ihrer Graphitelektrode in eine andere Stufe erfolgen, wobei sich der Übergang in die zweite Stufe besonders effizient erfassen lässt. Hieraus kann dann auf die aktuelle Kapazität der Batterieeinzelzelle geschlossen werden. Trägt man also die Ruhespannung von Lithium gegenüber Graphit über der Kapazität der Batterieeinzelzelle auf, erhält man ein charakteristisches Diagramm, welches so prinzipiell aus dem Stand der Technik bekannt ist und auch in der oben genannten Dissertation, insbesondere auf den Seiten 40 ff, entsprechend thematisiert wird. Dabei sind verschiedene Stufen (Stages) innerhalb der Ruhespannungskurve charakteristisch. Der Übergang von einer Stufe auf die andere erlaubt dann Rückschlüsse auf die aktuelle Kapazität der Batterieeinzelzelle.

Besonders effizient lässt sich der Schnittpunkt bestimmen, wenn man gemäß einer sehr vorteilhaften Ausgestaltung des erfindungsgemäßen Verfahrens die Lade- und Entladekurven mit einem logarithmischen Auftrag der Relaxationszeitkonstanten über der Ladung der Batterieeinzelzelle aufträgt. Im Wesentlichen entstehen dann zwei Kurven, also eine Lade- und eine Entladekurve, welche sehr gut durch Geraden angenähert werden können. Diese bilden einen definierten Schnittpunkt aus, über welchen relativ exakt auf die Lage des Übergangs z.B. in die zweite Stufe in der Ruhespannungskurve geschlossen werden kann.

Liegen diese Wert nun vor, so ist man in der Lage, einen modellbasierten Ansatz zu nutzen, um anhand der aktuellen Kapazität der Batterieeinzelzelle eine aktuelle Ruhespannungskurve von Lithium gegenüber Graphit aus einer vorgegebenen Ruhespannungskurve der Batterieeinzelzelle zu Beginn ihres Lebens zu errechnen. Die aktuelle Ruhespannungskurve wird hierfür gemäß einer sehr vorteilhaften Weiterbildung des Verfahrens gemäß der Erfindung insbesondere durch eine Stauchung der vorgegebenen Ausgangskurve zu Beginn des Lebens der Batterieeinzelzelle entlang der Richtung der Kapazität erreicht. Dieses Stauchen kann insbesondere so lange vorgenommen werden, bis der Übergang in die zweite Stufe dieser gestauchten Ausgangskurve mit dem entsprechenden Übergang der aktuellen Ruhespannungskurve in die zweite Stufe übereinstimmt. Der Übergang lässt sich also als Referenzpunkt nutzen, um von einer grundlegend bekannten Ausgangskurve der Batterieeinzelzelle bzw. ihrer Graphitelektrode auf die aktuelle Ruhespannungskurve zu kommen. Damit lässt sich so eine aktuelle Ruhespannungskurve mit relativ hoher Genauigkeit modellieren, und zwar auf der Basis einer einfachen und auch im Betrieb der Batterie, beispielsweise in einem Fahrzeug, möglichen Messung.

Im Weiteren werden dann die aktuellen und die gespeicherten Relaxationszeitkonstanten in Relation zu dieser simulierten aktuellen Spannungskurve von Lithium gegenüber Graphit über den Ladezustand der Batterieeinzelzelle gebracht. Typischerweise liegen die Maxima im Bereich der Übergänge zwischen den einzelnen Stufen, also am Übergang von Stage 2 zu Stage 1, sowie gegebenenfalls auch am Übergang von Stage 3L zu Stage 4L.

Die Relaxationszeitkonstanten selbst können bei dem erfindungsgemäßen Verfahren direkt oder mittelbar aus der Mindestspannung, dem Mindestladeumsatz, der Mindestzeit bis zum Erreichen einer zeitlich weitgehend konstanten Spannung der Batterieeinzelzelle und/oder anhand eines Gradienten, also der Steigung, der Spannungsantwort der Batterieeinzelzelle auf den Leistungspuls mit Hilfe einer vorgegebenen Korrelation von Gradienten und Relaxationszeitkonstante, welche insbesondere in einer Lookup-Tabelle hinterlegt sein kann, ermittelt werden. Die tatsächliche Messung der Mindestzeit wäre hier sicherlich die bevorzugte Lösung, erfordert aber eine relativ lange Leerlaufphase. Deshalb kann vor allem die Steigung der Spannungsantwort der Batterieeinzelzelle auf den Leistungspuls genutzt werden. Verschiedene aufgetretene Spannungen können aus historisch bekannten Korrelationen bestimmten Relaxationszeitkonstanten zugeordnet werden, sodass beispielsweise über in einer Tabelle hinterlegte Wert anhand der Steigung bereits bei einer sehr kurzen Leerlaufzeit eine einigermaßen zuverlässige Aussage über die Relaxationszeitkonstante getroffen werden kann.

Dabei ist es nun so, dass gemäß einer sehr vorteilhaften Weiterbildung des erfindungsgemäßen Verfahrens die aktuell ermittelte Relaxationszeitkonstante mit zuvor ermittelten und gespeicherten Relaxationszeitkonstanten verglichen wird, wobei anhand einer Zunahme des Werts der Relaxationszeitkonstanten auf eine stärker werdende Deckschichtbildung der Batterieeinzelzelle bzw. ihrer Graphitelektrode geschlossen wird. Eine solche Deckschichtbildung, welche quasi die Zugänglichkeit des Aktivmaterials beschränkt, beschränkt auch den Ausgleich der Lithium-Ionen, sodass die Relaxationszeit entsprechend ansteigt. Eine über mehrere ermittelte Werte hinweg steigende Relaxationszeitkonstante ist also ein deutlicher Hinweis auf eine solche stärker werdende Deckschichtbildung der Batterieeinzelzelle bzw. ihrer Graphitelektrode, womit ein erster konkreter Alterungsmechanismus entsprechend erkannt worden ist.

Gemäß einer weiteren sehr vorteilhaften Ausgestaltung kann es vorgesehen sein, dass anhand einer Verschiebung der Relaxationszeitkonstanten in Richtung geringerer Kapazitäten, insbesondere in der aktuellen Ruhespannungskurve von Lithium gegenüber Graphit über der Kapazität der Batterieeinzelzelle, auf einen zunehmenden Verlust von Aktivmaterial der Anode geschlossen wird. Eine solche Verschiebung, insbesondere in dem oben angesprochenen Diagramm der aktuellen Ruhespannungskurve in Richtung geringerer Kapazitäten, also in einem solchen Diagramm in x-Richtung nach links, steht also für einen zunehmenden Verlust an Aktivmaterial der Anode. Dieser zweite konkrete Alterungsmechanismus wird auch mit LAAM (Loss of Active Anode Material) bezeichnet.

Eine weitere sehr vorteilhafte Ausgestaltung des erfindungsgemäßen Verfahrens ermöglicht es ferner alternativ oder ergänzend zu den beiden bisherigen Alterungsmechanismen anhand einer Verringerung des Abstands der aktuellen Relaxationszeitkonstante zu der zuletzt gespeicherten Relaxationszeitkonstanten im Vergleich zu dem Abstand zuvor gespeicherter Paarungen von Relaxationszeitkonstanten über der Kapazität, und auch hier insbesondere wieder in der aktuellen Ruhespannungskurve von Lithium gegenüber Graphit über der Kapazität der Batterieeinzelzelle, auf einen zunehmenden Verlust von Lithium zu schließen. Der zunehmende Verlust von Lithium, welcher auch als LLi (Loss of Lithium) bezeichnet wird, kann also erkannt werden, wenn der Abstand zwischen den einzelnen Relaxationszeitkonstanten in dem Diagramm geringer wird. Das heißt die Relaxationszeitkonstanten rücken bezogen auf die Kapazitätsachse weiter zusammen. Damit kann also ein dritter Alterungsmechanismus konkret erkannt werden.

Alle drei beschriebenen Mechanismen lassen sich nun zusammen oder unabhängig voneinander in der modellbasierten Auswertung der erfassten Relaxationszeitkonstanten ermitteln. Jeder der Alterungsmechanismen hat dabei einen unterschiedlichen Einfluss auf die Relaxationszeitkonstante, sodass aus den Messwerten alle drei Alterungsmechanismen abgelesen werden können. Wenn nun der konkret in der Batterieeinzelzelle bzw. ihrer Graphitelektrode vorliegende Alterungsmechanismus bekannt ist, lässt sich nun sehr gezielt eben diesem Alterungsmechanismus entgegenwirken. So können beispielsweise die Leistungszufuhr zu und die Leistungsentnahme aus der Batterie beim Laden und Entladen im Betrieb so angepasst werden, oder es kann die Kühlung bzw. Temperierung der Batterie verändert werden, um die Batterieeinzelzellen entsprechend schonend zu betreiben.

Unter Bezugnahme auf die durch die modellbasierte Analyse erhältliche aktuelle Ruhespannungskurve der Batterieeinzelzelle könnte dieses erfindungsgemäße Verfahren zum Steuern der Leistungszufuhr zu und der Leistungsentnahme aus der Batterie dahingehend angepasst werden, dass ein Laden und Entladen der jeweiligen Batterieeinzelzelle über die Grenze der Stufen der Ruhespannungskurve hinweg nach Möglichkeit vermieden wird. Wann immer möglich sollte also das Laden und Entladen innerhalb einer der Stufen erfolgen, nur in Ausnahmefällen sollten diese entsprechend überschritten werden. Hierdurch lässt sich das Fortschreiten der Alterung der Batterieeinzelzelle, und hier insbesondere ihrer Graphitelektrode, entsprechend aufhalten bzw. minimieren.

Weitere vorteilhafte Ausgestaltungen der beiden erfindungsgemäßen Verfahren ergeben sich auch aus den Ausführungsbeispielen und werden nachfolgend anhand der Figuren näher erläutert.

Dabei zeigen:
- Fig. 1: eine schematische Darstellung des Verfahrensablaufs für eine mögliche Ausführungsform des erfindungsgemäßen Verfahrens;
- Fig. 2: eine Darstellung der Korrelation zwischen Ladung und Relaxationszeitkonstanten;
- Fig. 3: ein prinzipielles Ruhespannungsdiagramm einer lithiierten Graphitelektrode;
- Fig. 4: das Ruhespannungsdiagramm gemäß Fig. 3 mit zusätzlich eingezeichneter Ruhespannungskurve einer gealterten Batterieeinzelzelle und mit zusätzlich eingezeichneten erfassten und gespeicherten Relaxationszeitkonstanten im Falle einer Deckschichtbildung;
- Fig. 5: das Ruhespannungsdiagramm gemäß Fig. 3 mit zusätzlich eingezeichneter Ruhespannungskurve einer gealterten Batterieeinzelzelle und mit zusätzlich eingezeichneten erfassten und gespeicherten Relaxationszeitkonstanten im Falle eines Verlusts von Anodenaktivmaterial (LAAM);
- Fig. 6: das Ruhespannungsdiagramm gemäß Fig. 3 mit zusätzlich eingezeichneter Ruhespannungskurve einer gealterten Batterieeinzelzelle und mit zusätzlich eingezeichneten erfassten und gespeicherten Relaxationszeitkonstanten im Falle eines Lithiumverlusts (LLi); und
- Fig. 7: eine schematische Darstellung eines Pufferkonzepts zur Durchführung des Verfahrens gemäß der Fig. 1.

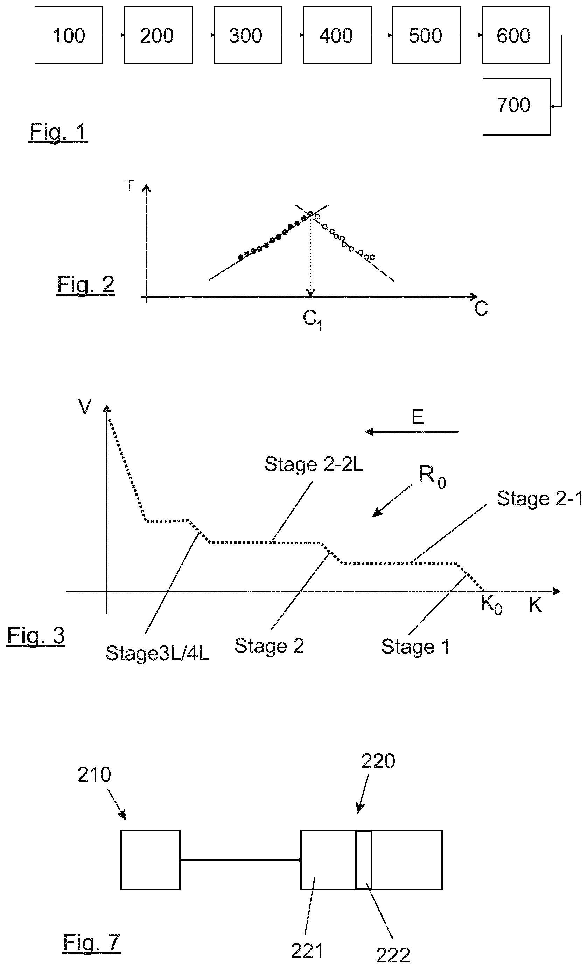

In der Darstellung der Figur 1 ist ein möglicher Verfahrensablauf zur Bestimmung der Alterung einer Batterieeinzelzelle und einer darauf basierenden Veränderung des Betriebsverfahrens für die Batterie schematisch dargestellt. In der mit 100 bezeichneten Box wird beispielsweise eine starke Stromentnahme, also ein Leistungspuls, bei einer Batterie bzw. zumindest einer ihrer Batterieeinzelzellen detektiert. In der Box 200 erfolgt nun eine Aufzeichnung des Strompulses und der Spannungsantwort der Batterieeinzelzelle hierauf. In einer nachfolgenden Phase mit geringerer oder ohne Leistungsentnahme oder -zufuhr, welche hier als Leerlaufphase bezeichnet wird, erfolgt eine Bewertung der Relaxation der Batterieeinzelzelle. Im Schritt 400 wird dann eine Relaxationsspannung und eine Relaxationszeitkonstante berechnet, wie dies prinzipiell aus eingangs genannter Dissertation bekannt ist. Im Schritt 500 erfolgt nun eine Korrelation zwischen der Ladung C und verschiedenen Relaxationszeitkonstanten τ, welche bereits erfasst und gespeichert und/oder aktuell ermittelt wurden. Hierauf wird nachfolgend im Rahmen der Figur 2 noch näher eingegangen.

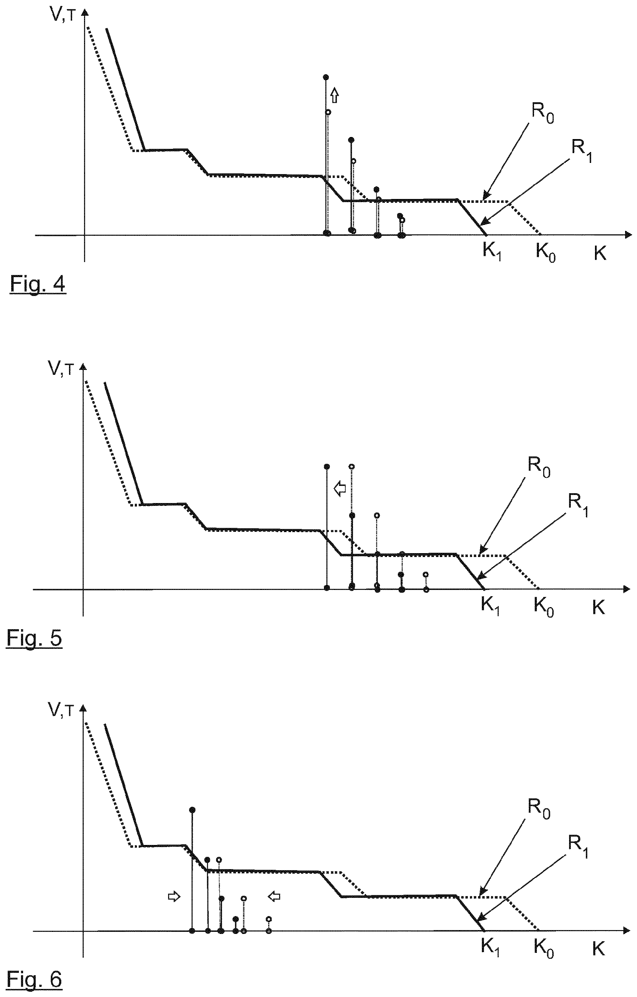

Im Schritt 600 kann nun optional eine modellbasierte Alterungsbestimmung erfolgen, wobei diese verschiedenen Alterungsmechanismen wie beispielsweise eine Deckschichtbildung, LAAM und/oder LLi erfassen kann und damit besonders vorteilhaft ist. Hierauf wird in den Figuren 4 bis 6 näher eingegangen. Im ebenfalls optionalen Schritt 700 können diese erkannten Alterungsmechanismen nun genutzt werden, um eine entsprechend angepasste Betriebsstrategie für die Batterie zu wählen, also bestimmte Betriebszustände zu vermeiden und die Batterie sowohl bezüglich des Ladens, des Entladens als auch bezüglich ihrer Temperierung über ein Kühlmedium möglichst schonend zu betreiben, um eine fortschreitende Alterung zu verhindern oder deren Fortschritt zumindest zu verlangsamen.

Verschiedene berechnete Relaxationszeitkonstanten τ, welche beispielsweise bei einem zum Laden oder Entladen genutzten Leistungspuls aufgetreten sind, wurden im Schritt 400 berechnet und gespeichert. Gemäß den Schritt 500 trägt man in Figur 2 die einzelnen Relaxationszeitkonstanten τ über der Ladung C auf, so ergibt sich bei einer logarithmischen Skala für die Relaxationszeitkonstanten **τ** entlang der schwarz dargestellten Punkte für die Ladezyklen und entlang der weiß dargestellten Punkte für die Entladezyklen jeweils eine Gerade. Deren Schnittpunkt erlaubt dann über die daraus ermittelte Ladung C₁ Rückschlüsse auf die zum aktuellen Zeitpunkt vorliegende Kapazität K der Batterieeinzelzelle bzw. ihrer für den Alterungsmechanismus im Wesentlichen bestimmende Graphitelektrode (Anode).

In der Darstellung der Figur 3 ist eine schematische Ruhespannungskurve R₀ von Lithium gegenüber Graphit über der Kapazität K der Batterieeinzelzelle bzw. ihrer Graphitelektrode aufgezeigt. Auf der y-Achse ist hier die Ruhespannungslage V aufgetragen, auf der x-Achse die Zellkapazität K der lithiierten Graphitelektrode mit Normierung auf die Stage 3L bzw. Stage 4L (s.u.) aufgezeigt. Die Ruhespannungskurve R₀ ist Figur 3 die einer neuen Batterieeinzelzelle bzw. Graphitelektrode. Die initiale Kapazität der Batterieeinzelzelle bzw. ihrer Graphitelektrode beim Beginn ihres Lebens ist hier mit K₀ angedeutet. Die Ruhespannung von Null am Punkt der initialen Kapazität K₀ zeigt dabei den vollgeladenen Zustand an, von rechts nach links ist hier also die Endladerichtung E der Gesamtzelle dargestellt. Die Ruhespannungskurve R₀ hat dabei charakteristische auch als Stages bezeichnete Stufen. Diese werden von rechts nach links entlang der Kapazität als Stage 1, als Stage 2-1, als Stage 2-2L, als Stage 3L/4L bezeichnet.

In diese mit der initialen Kapazität K₀ bekannte Ruhespannungskurve R₀ lässt sich nun eine Ruhespannungskurve R₁ mit der aktuellen Kapazität K₁ hineinmodellieren. Die Ruhespannungskurve R₁ mit der aktuellen Kapazität K₁ wird entsprechend in Richtung der Kapazität K gestaucht aus der Ausgangskurve mit initialer Kapazität K₀ hervorgehen. Die gealterte Kapazität K₁ wird also unterhalb der initialen Kapazität K₀ liegen, wobei sich hier nun an den verschiedenen Stellen dieser Ruhespannungskurven R₀, R₁ verschiedene Dinge ablesen lassen.

In der Wissenschaft ist der Sachverhalt bekannt, dass ein Verlust von Anodenaktivmaterial (LAAM) ein Schrumpfen der Kapazität K von rechts mit sich bringt, daher wird eine voll lithiierte Graphitelektrode schneller erreicht. Auf der linken Seite wird durch den Verlust von Lithium (LLi) eine Einschränkung der Kapazität K verursacht. Im Folgenden wird darauf eingegangen, wie sich diese beiden Effekte auf die Relaxationszeitkonstante τ auswirken und zusätzlich wird noch eine Auswirkung auf die Bildung von Deckschichten diskutiert.

In den Figuren 4 bis 6 sind dazu jeweils zwei schematische Ruhespannungskurven R₀, R₁ der lithiierten Graphitelektrode zu sehen. Eine ungealterte punktiert dargestellte (Analog Figur 3) Ruhespannungskurve R₀ und eine gealterte, mit durchgezogener Linie dargestellte Ruhespannungskurve R₁. Die y-Achse stellt dabei einmal die Zeit der Relaxationszeitkonstanten τ in Sekunden dar und einmal die Ruhespannungslage V gegen Lithium. Auf der x-Achse ist wieder die Kapazität K mit Normierung auf die Stage 3L/4L aufgezeigt. Die Lage der Ruhespannungskurve R₁ bei gealterter Graphitelektrode ergibt sich dabei aus der über das in Figur 2 erläuterte Diagramm erfassten aktuellen Ladung C₁ und der daraus abgeleiteten gealterten Kapazität.

Neben der Ruhespannungskurve R₀, R₁ der neuen und der gealterten Graphitelektrode sind in dem Diagramm der Figur 4 außerdem die Relaxationszeitkonstanten τ mit eingezeichnet. Die Relaxationszeitkonstanten τ der neuen Graphitelektrode sind dabei analog zur Darstellung der Ruhespannungskurve R₀ mit punktierten von Null zur entsprechenden Relaxationszeitkonstante τ verlaufenden Linien eingezeichnet, die der gealterten Batterieeinzelzelle mit durchgezogener Linie.

In dem Diagramm der Figur 4 ist zu erkennen, dass die Relaxationszeitkonstanten τ der gealterten Graphitelektrode höhere Werte annehmen, als diejenigen der neuen Graphitelektrode in den entsprechenden Positionen. Eine solche Erhöhung der Relaxationszeitkonstanten τ deutet dabei auf eine zunehmende Decksichtbildung als einen der Alterungsmechanismen in der Graphitelektrode hin.

In Figur 5 ist analog zur Darstellung in Figur 4 die Auswirkung von LAAM auf die Relaxationszeitkonstante τ gezeigt. Mit der Verringerung der Kapazität K, verursacht durch LAAM, verschiebt sich die Relaxationszeitkonstante τ zu einem tieferen Ladezustand (in Bezug auf die initiale Kapazität). Die Relaxationszeitkonstanten τ sind wieder durch die Datenpunkte angedeutet. Dabei sind die punktierten Datenpunkte der ursprüngliche (frische) Zustand und die durchgezogenen Datenpunkte stellen die durch Alterung verschobene Relaxationszeitkonstante τ dar.

In Figur 6 ist analog zur Darstellung in den vorherigen Figuren 4 und 5 die Auswirkung von LLi auf die Relaxationskonstante τ gezeigt. Durch den Lithium-Verlust steigt die Steilheit, mit der die Relaxationszeitkonstanten τ ansteigen. Wird nun bei der Entladung an mehreren Stellen die Relaxationskonstante τ bestimmt, kann über die Steilheit der Änderung der Zeitkonstante auf den Grad des Lithiumverlusts zurückgeschlossen werden. Die Gruppe von erfassten Relaxationszeitkonstanten τ der neuen Graphitelektrode sind wieder punktiert dargestellt, die der gealterten Graphitelektrode mit durchgezogenen Linien. Die Abstände der Werte innerhalb der Gruppe haben sich dabei durch die Alterung verringert, die Gruppe ist als zusammengeschoben worden.

Die über die drei Figuren 4, 5 und 6 gezeigten Mechanismen lassen sich also in den modellierten Daten auf Basis der erfassten Messwerte einfach automatisiert erkennen. Dabei sind typischerweise alle drei Mechanismen zueinander überlagert, was in der Sache jedoch nicht störend ist, da die drei Alterungsmechanismen so signifikant unterschiedliche Einflüsse auf die Relaxationszeitkonstante τ haben, dass diese auch bei einer entsprechenden Überlagerung einfach und effizient aus den vorliegenden Daten herausgelesen werden können.

Sobald in dem Verfahrensablauf der Figur 1 eine starke Stromentnahme detektiert wurde (Box 100), startet eine Aufzeichnung 200 des Stromwertes durch die Batterie bzw. Batterieeinzelzelle und des Spannungswertes der Batterieeinzelzelle. Vorteilhafterweise, wird diese Aufzeichnung 200 kontinuierlich und mit hoher Aufzeichnungsdynamik durchgeführt. Dies kann in einem in Figur 7 schematisch dargestellten ersten Puffer 210 mit hoher Dynamik erfolgen. Nach der Detektion eines für die Auswertung geeigneten Events aus Leistungspuls und folgender Leerlaufphase werden die aufgezeichneten Daten aus dem ersten Puffer 210 in einen zweiten Puffer 220 übertragen und dort als Kopie 221 gespeichert. Danach wird die Aufzeichnung 200 in dem zweiten Puffer 220 mit einer niedrigeren Dynamik fortgesetzt, was hier durch den Bereich 222 veranschaulicht wird. Dadurch kann man auch rückwirkend einen Strompuls bewerten und hat dabei für den Zeitraum mit einer niedrigeren Dynamik (während der Relaxation) einen geringeren Speicherverbrauch.

Die Aufzeichnung wird bis zum Erreichen eines Abbruchkriteriums fortgesetzt. Diese kann z.B. eine Mindestspannungsveränderung pro Zeit, ein Mindestladungsumsatz (nur höhere Umsätze machen Sinn für Inhomogenität) oder eine Mindestzeit sein.

Darauffolgend können die Relaxationsspannung und die Relaxationszeitkonstante τ berechnet werden. Die Relaxationszeitkonstante τ kann anschließend in eine Tabelle eingefügt werden, die z.B. der Ladung C, dem Ladezustand SOC oder die Kapazität K mit der Relaxationszeitkonstante τ verbindet. Dies kann sowohl für Entlade- als Ladepulse durchgeführt werden. Mithilfe von mehreren dieser Relaxationszeitkonstanten τ kann dann das Verhalten von Entlade- und Ladepulse korreliert werden, z.B. per Regressionsanalyse, um den Schnittpunkt zwischen maximaler Relaxationszeitkonstante τ in Entlade- und Laderichtung zu finden. (Figur 2) An dieser Stelle befindet sich der Übergangspunkt und kann zur Bewertung von LLi und LAAM herangezogen werden. Dies kann sowohl Stage 3L/4L, als auch die Stage 2 und die Stage 1 erfolgen, um die Entwicklung der unterschiedlichen Alterungseffekte zu quantifizieren.

Mithilfe der Quantifizierung können nun im Schritt 700 des Verfahrens die Betriebsgrenzen und Betriebsstrategie angepasst werden. Dies können z.B. die alterungsbedingte Begrenzung des Lade- oder Entladestroms sein oder eine Anpassung der Betriebsstrategie auf die Nutzung eines mittleren Betriebsfensters. Es ist ebenfalls denkbar, dass sich aus den berechneten Alterungsgrößen eine höhere Anforderung bezüglich der Kühlung oder Erwärmung und eine entsprechende Anpassung der Thermostrategie ergibt.

Insbesondere wird dieses Verfahren sinnvoll, wenn man es über eine Fahrzeugflotte aggregiert und in einem Backend-Server Auswertungen macht. Zusätzlich zu den üblichen Bewertungskriterien (Kapazität, Widerstand) kann dann auch noch die Homogenität der Lithiumverteilung in den unterschiedlichen Stages bewertet werden.

## Patentansprüche

1. Verfahren zur Bestimmung der Alterung einer Batterieeinzelzelle einer Lithium-Ionen-Batterie,
wobei die Batterieeinzelzelle mit einem Leistungspuls aktiv be- oder entladen wird, oder dass ein solcher die Batterieeinzelzelle ladender oder entladender Leistungspuls im Betrieb der Batterie detektiert wird, wobei der auftretende Strompuls und die Spannungsantwort der Batterieeinzelzelle in einer auf den Leistungspuls folgenden Leerlaufphase mit geringerer Leistung oder ohne Leistung aufgezeichnet und die Relaxation der Batterieeinzelzelle bewertet wird, wobei zumindest die Relaxationszeitkonstante (τ) ermittelt und gespeichert wird,
**dadurch gekennzeichnet, dass**
aus der aktuell erfassten und aus bereits gespeicherten Relaxationszeitkonstanten (τ) beim Laden oder Entladen der Batterieeinzelzelle durch den Leistungspuls jeweils eine Lade- und eine Entladekurve über der Ladung der Batterieeinzelzelle gebildet wird, wobei anhand des Schnittpunkts der Ladekurve und der Entladekurve auf eine aktuelle Kapazität (K₁) der Batterieeinzelzelle geschlossen wird.

2. Verfahren nach Anspruch 1,
**dadurch gekennzeichnet, dass**
anhand des durch den Schnittpunkt bestimmten Übergangs von einer Stufe in eine andere Stufe auf einer Ruhespannungskurve (R₀, R₁) von Lithium gegenüber Graphit über der Kapazität (K) der Batterieeinzelzelle auf die aktuelle Kapazität (K₁) der Batterieeinzelzelle geschlossen wird.

3. Verfahren nach Anspruch 1 oder 2,
**dadurch gekennzeichnet, dass**
die Lade und Entladekurven durch eine logarithmische Auftragung der Relaxationszeitkonstanten (τ) über der Ladung der Batterieeinzelzelle gebildet werden.

4. Verfahren nach Anspruch 2 oder 3,
**dadurch gekennzeichnet, dass**
anhand der aktuellen Kapazität (K₁) der Batterieeinzelzelle eine aktuelle Ruhespannungskurve (R₁) von Lithium gegenüber Graphit über der Kapazität (K) der Batterieeinzelzelle aus einer vorgegebenen Ruhespannungskurve (R₀) zu Beginn des Lebens der Batterieeinzelzelle errechnet wird.

5. Verfahren nach Anspruch 4,
**dadurch gekennzeichnet, dass**
die aktuelle Ruhespannungskurve (R₁) durch eine Stauchung der vorgegebenen Ausgangskurve (R₀) entlang der Richtung der Kapazität (K), bis zur Übereinstimmung des bestimmten Übergangs zwischen zwei der Stufen mit dem entsprechenden Übergang der aktuellen Ruhespannungskurve (R₀) ermittelt wird.

6. Verfahren nach Anspruch 4 oder 5,
**dadurch gekennzeichnet, dass**
die aktuelle und die gespeicherten Relaxationszeitkonstanten (τ) in Relation zu der aktuellen Ruhespannungskurve (R₀) gebracht werden.

7. Verfahren nach einem der Ansprüche 1 bis 6,
**dadurch gekennzeichnet, dass**
die Relaxationszeitkonstante (τ) direkt oder mittelbar aus der Mindestspannung, dem Mindestladeumsatz, der Mindestzeit bis zum Erreichen einer zeitlich weitgehend konstanten Spannung der Batterieeinzelzelle und/oder anhand eines Gradienten der Spannungsantwort der Batterieeinzelzelle mit Hilfe einer vorgegeben Korrelation von Gradienten und Relaxationszeitkonstante (τ), insbesondere aus einer Tabelle, ermittelt wird.

8. Verfahren nach einem der Ansprüche 1 bis 7,
**dadurch gekennzeichnet, dass**
die aktuell ermittelte Relaxationszeitkonstante (τ) mit zuvor ermittelten und gespeicherten Relaxationszeitkonstanten (τ) verglichen wird, wobei anhand einer Zunahme des Werts der Relaxationszeitkonstanten (τ) auf eine stärker werdende Decksichtbildung in der Batterieeinzelzelle geschlossen wird.

9. Verfahren nach einem der Ansprüche 1 bis 8,
**dadurch gekennzeichnet, dass**
anhand einer Verschiebung der Relaxationszeitkonstanten (τ) in Richtung geringerer Kapazitäten (K), insbesondere in einer aktuellen Ruhespannungskurve (R₁) von Lithium gegenüber Graphit über der Kapazität (K) der Batterieeinzelzelle, auf einen zunehmenden Verlust von Anodenaktivmaterial (LAAM) geschlossen wird.

10. Verfahren nach einem der Ansprüche 1 bis 9,
**dadurch gekennzeichnet, dass**
anhand einer Verringerung des Abstands der aktuellen Relaxationszeitkonstante (τ) zu der zuletzt gespeicherten Relaxationszeitkonstante (τ) im Vergleich zu dem Abstand zuvor gespeicherter Paarungen von Relaxationszeitkonstanten (τ) über der Kapazität (K), insbesondere in einer aktuellen Ruhespannungskurve (R₁) von Lithium gegenüber Graphit über der Kapazität (K) der Batterieeinzelzelle, auf einen zunehmenden Verlust von Lithium (LLi) geschlossen wird.

11. Verfahren zum Steuern einer Batterie mit wenigstens einer Batterieeinzelzelle, für welche die Alterung gemäß einem Verfahren nach einem der Ansprüche 1 bis 10 bestimmt worden ist,
**dadurch gekennzeichnet, dass**
die Leistungszufuhr zu und die Leistungsentnahme aus einer Batterie beim Laden und Entladen im Betrieb so angepasst wird, dass erkannten Alterungsmechanismen entgegengewirkt oder diese zumindest nicht verstärkt werden.

12. Verfahren nach Anspruch 11,
**dadurch gekennzeichnet, dass**
ein Laden und Entladen der jeweiligen Batterieeinzelzelle über die Grenze ihrer Stufen in der Ruhespannungskurve von Lithium gegenüber Graphit über der Kapazität Batterieeinzelzelle möglichst vermieden wird.

13. Verfahren nach Anspruch 11 oder 12,
**dadurch gekennzeichnet, dass**
das Wärmemanagement der Batterie im Betrieb so angepasst wird, dass erkannten Alterungsmechanismen entgegengewirkt oder diese zumindest nicht verstärkt werden.

## Claims

1. Method for determining the aging of an individual battery cell of a lithium-ion battery,
wherein
the individual battery cell is actively charged or discharged with a power pulse, or that such a power pulse which charges or discharges the individual battery cell is detected during operation of the battery, wherein the occurring current pulse and the voltage response of the individual battery cell are recorded in an idle phase with lower power or without power following the power pulse, and the relaxation of the individual battery cell is evaluated, wherein at least the relaxation time constant (τ) is determined and stored, **characterized in that,**
from the currently recorded and already stored relaxation time constants (τ), during charging or discharging of the individual battery cell by means of the power pulse, a charging curve and a discharging curve are formed with respect to the charge of the individual battery cell in each case, wherein, based on the point of intersection of the charging curve and the discharging curve, a conclusion is drawn about a current capacity (K₁) of the individual battery cell.

2. Method according to claim 1,
**characterized in that**
based on the transition from one stage to another stage, which is determined by the point of intersection, on an open-circuit voltage curve (R₀, R₁) of lithium relative to graphite with respect to the capacity (K) of the individual battery cell, a conclusion is drawn about the current capacity (K₁) of the individual battery cell.

3. Method according to claim 1 or claim 2,
**characterized in that**
the charging and discharging curves are formed by a logarithmic plot of the relaxation time constant (τ) with respect to the charge of the individual battery cell.

4. Method according to claim 2 or claim 3,
**characterized in that**
based on the current capacity (K₁) of the individual battery cell, a current open-circuit voltage curve (R₁) of lithium relative to graphite with respect to the capacity (K) of the individual battery cell is calculated from a specified open-circuit voltage curve (R₀) at the beginning of the life of the individual battery cell.

5. Method according to claim 4,
**characterized in that**
the current open-circuit voltage curve (R₁) is determined by compressing the specified output curve (R₀) along the direction of the capacity (K) until the determined transition between two of the stages coincides with the corresponding transition of the current open-circuit voltage curve (R₀).

6. Method according to claim 4 or claim 5,
**characterized in that**
the current and the stored relaxation time constants (τ) are brought into relation with the current open-circuit voltage curve (R₀).

7. Method according to any of claims 1 to 6,
**characterized in that**
the relaxation time constant (τ) is determined directly or indirectly from the minimum voltage, the minimum charge rate, the minimum time until a largely constant voltage of the individual battery cell is reached, and/or is determined based on a gradient of the voltage response of the individual battery cell using a specified correlation of gradient and relaxation time constant (τ), in particular from a table.

8. Method according to any of claims 1 to 7,
**characterized in that**
the currently determined relaxation time constant (τ) is compared with previously determined and stored relaxation time constants (τ), wherein, based on an increase in the value of the relaxation time constant (τ), a conclusion is drawn about an increasing formation of a surface layer in the individual battery cell.

9. Method according to any of claims 1 to 8,
**characterized in that**
based on a shift of the relaxation time constant (τ) in the direction of lower capacities (K), in particular in a current open-circuit voltage curve (R₁) of lithium relative to graphite with respect to the capacity (K) of the individual battery cell, a conclusion is drawn about an increasing loss of anode active material (LAAM).

10. Method according to any of claims 1 to 9,
**characterized in that**
based on a reduction in the distance between the current relaxation time constant (τ) and the last stored relaxation time constant (τ) compared to the distance between previously stored pairs of relaxation time constants (τ) with respect to the capacity (K), in particular in a current open-circuit voltage curve (R₁) of lithium relative to graphite with respect to the capacity (K) of the individual battery cell, a conclusion is drawn about an increasing loss of lithium (LLi).

11. Method for controlling a battery having at least one individual battery cell for which the aging has been determined according to a method according to any of claims 1 to 10,
**characterized in that**
the power supply to and power extraction from a battery during charging and discharging during operation is adjusted such that identified aging mechanisms are counteracted or at least not increased.

12. Method according to claim 11,
**characterized in that**
charging and discharging of the relevant individual battery cell beyond the limit of its stages in the open-circuit voltage curve of lithium relative to graphite with respect to the capacity of the individual battery cell is avoided as much as possible.

13. Method according to claim 11 or claim 12,
**characterized in that**
the thermal management of the battery is adjusted during operation such that identified aging mechanisms are counteracted or at least not increased.

## Revendications

1. Procédé pour la détermination du vieillissement d'une cellule individuelle de batterie d'une batterie lithium-ion,
dans lequel
la cellule individuelle de batterie est chargée ou déchargée activement avec une impulsion de puissance, ou en ce qu'une telle impulsion de puissance chargeant ou déchargeant la cellule individuelle de batterie est détectée pendant le fonctionnement de la batterie, dans lequel l'impulsion de courant se produisant et la réponse en tension de la cellule individuelle de batterie sont enregistrées dans une phase de marche à vide suivant l'impulsion de puissance avec une puissance plus faible ou sans puissance et la relaxation de la cellule individuelle de batterie est évaluée, dans lequel au moins la constante de temps de relaxation (τ) est déterminée et enregistrée, **caractérisé en ce que**
à partir des constantes de temps de relaxation (τ) actuellement détectées et des constantes de temps de relaxation déjà enregistrées lors de la charge ou de la décharge de la cellule individuelle de batterie par l'impulsion de puissance, respectivement une courbe de charge et une courbe de décharge concernant la charge de la cellule individuelle de batterie sont formées, dans lequel on conclut à une capacité actuelle (K₁) de la cellule individuelle de batterie à l'aide du point d'intersection de la courbe de charge et de la courbe de décharge.

2. Procédé selon la revendication 1,
**caractérisé en ce que**
à l'aide de la transition déterminée par le point d'intersection d'un niveau à un autre niveau sur une courbe de tension de repos (R₀, R₁) du lithium par rapport au graphite concernant la capacité (K) de la cellule individuelle de batterie, on conclut à la capacité actuelle (K₁) de la cellule individuelle de batterie.

3. Procédé selon la revendication 1 ou 2,
**caractérisé en ce que**
les courbes de charge et de décharge sont formées par un tracé logarithmique des constantes de temps de relaxation (τ) concernant la charge de la cellule individuelle de batterie.

4. Procédé selon la revendication 2 ou 3,
**caractérisé en ce que**
à l'aide de la capacité actuelle (K₁) de la cellule individuelle de batterie, une courbe de tension de repos actuelle (R₁) du lithium par rapport au graphite concernant la capacité (K) de la cellule individuelle de batterie est calculée à partir d'une courbe de tension de repos (R₀) prédéfinie au début de la vie de la cellule individuelle de batterie.

5. Procédé selon la revendication 4,
**caractérisé en ce que**
la courbe de tension de repos actuelle (R₁) est déterminée par une compression de la courbe de sortie (R₀) prédéfinie le long de la direction de la capacité (K), jusqu'à ce que la transition déterminée entre deux des niveaux coïncide avec la transition correspondante de la courbe de tension de repos actuelle (R₀).

6. Procédé selon la revendication 4 ou 5,
**caractérisé en ce que**
les constantes de temps de relaxation (τ) actuelle et enregistrées sont mises en relation avec la courbe de contrainte de repos actuelle (R₀).

7. Procédé selon l'une des revendications 1 à 6,
**caractérisé en ce que**
la constante de temps de relaxation (τ) est déterminée directement ou indirectement à partir de la tension minimale, du taux de charge minimal, du temps minimal pour atteindre une tension largement constante dans le temps de la cellule individuelle de batterie et/ou à l'aide d'un gradient de la réponse en tension de la cellule individuelle de batterie à l'aide d'une corrélation prédéfinie de gradients et de la constante de temps de relaxation (τ), en particulier à partir d'un tableau.

8. Procédé selon l'une des revendications 1 à 7,
**caractérisé en ce que**
la constante de temps de relaxation (τ) actuellement déterminée est comparée avec des constantes de temps de relaxation (τ) déterminées et enregistrées précédemment, dans lequel, à l'aide d'une augmentation de la valeur des constantes de temps de relaxation (τ), on conclut à une augmentation de la formation d'une couche de recouvrement dans la cellule individuelle de batterie.

9. Procédé selon l'une des revendications 1 à 8,
**caractérisé en ce que**
à l'aide d'un décalage des constantes de temps de relaxation (τ) en direction de capacités (K) plus faibles, en particulier dans une courbe de tension de repos actuelle (R₁) du lithium par rapport au graphite concernant la capacité (K) de la cellule individuelle de batterie, on conclut à une perte croissante de matériau actif d'anode (LAAM).

10. Procédé selon l'une des revendications 1 à 9,
**caractérisé en ce que**
à partir d'une réduction de l'écart entre la constante de temps de relaxation (τ) actuelle et la dernière constante de temps de relaxation (τ) enregistrée par rapport à l'écart entre des paires de constantes de temps de relaxation (τ) précédemment enregistrées concernant la capacité (K), en particulier dans une courbe de tension de repos actuelle (R₁) du lithium par rapport au graphite concernant la capacité (K) de la cellule individuelle de batterie, on conclut à une perte croissante de lithium (LLi).

11. Procédé pour la commande d'une batterie comportant au moins une cellule individuelle de batterie pour laquelle le vieillissement a été déterminé selon un procédé selon l'une des revendications 1 à 10,
**caractérisé en ce que**
l'alimentation en puissance d'une batterie et le prélèvement de puissance de celle-ci lors de la charge et de la décharge lors du fonctionnement sont adaptés de sorte qu'ils contrecarrent des mécanismes de vieillissement identifiés ou du moins ne les renforcent pas.

12. Procédé selon la revendication 11,
**caractérisé en ce que**
une charge et une décharge de la cellule individuelle de batterie respective au-delà de la limite de ses niveaux dans la courbe de tension de repos du lithium par rapport au graphite concernant la capacité de la cellule individuelle de batterie est évitée autant que possible.

13. Procédé selon la revendication 11 ou 12,
**caractérisé en ce que**
la gestion thermique de la batterie lors du fonctionnement est adaptée de sorte qu'elle contrecarre des mécanismes de vieillissement identifiés ou du moins ne les renforce pas.
